# FASCICULE DE BREVET EUROPEEN

(11) **EP 0 459 876 B1**
(45) Date de publication et mention de la délivrance du brevet: **09.11.1994**
(21) Numéro de dépôt: 91401335.4
(22) Date de dépôt: 23.05.1991
(51) Int. Cl.: H01R 13/66

(54) **Dispositif connecteur adaptateur de terminaison**
Terminal-Adapter als Verbindungsgerät
Terminal adaptor as connector device

(30) Priorité: 30.05.1990 FR 9006692
(43) Date de publication de la demande: 04.12.1991
(73) Titulaire: BULL S.A., 92800 Puteaux (FR)
(72) Inventeur: Cesar, Charles, Bull S.A., F-38130 Echirolles (FR)

(56) Documents cités:
- EP-A- 0 259 082
- FR-A- 2 577 353
- FR-A- 2 613 539

## Description

La présente invention concerne un dispositif connecteur adaptateur de terminaison comprenant, entre autres, un boîtier, logé dans le boîtier un connecteur d'un premier genre destiné à être connecté à l'extrémité d'une ligne d'un système électronique à un connecteur d'un second genre, sur lequel transitent des signaux, pour adapter ladite ligne et/ou simuler la connexion de la ligne à un dispositif extérieur, également logé dans le boîtier et relié au connecteur du premier genre un moyen de support et de liaison d'éléments d'adaptation et/ou de simulation.

Un tel dispositif connecteur adaptateur de terminaison est couramment utilisé pour tester ou adapter un système électronique ou simuler la connexion de celui-ci à un autre système électronique. Des exemples de tels dispositifs peuvent être trouvés dans les catalogues de composants électroniques, plus particulièrement de connecteurs, publiés par des fabricants comme par exemple 3M ou AMP. Ainsi pour terminer une ligne, il est courant d'utiliser des boîtiers connecteurs de petite dimension lesquels peuvent comporter des cavaliers, des fils électriques ou des résistances d'adaptation. Toutefois lorsqu'il est désiré intégrer dans les boîtiers connecteurs des circuits ou des éléments plus volumineux il est alors utilisé des circuits imprimés rigides soudés aux connecteurs, circuits sur lesquels sont disposés les éléments volumineux. Ceci impose alors, compte tenu de l'encombrement relativement au circuit imprimé et aux éléments portés par celui-ci, l'utilisation de boîtiers connecteurs également volumineux, ce qui peut présenter de graves inconvénients. En effet, force est de constater de nos jours une forte inclination à la miniaturisation. Ainsi les systèmes électroniques actuels sont inclus dans des volumes de plus en plus réduits et lorsque pour des besoins de test ou de simulation il est nécessaire d'utiliser des boîtiers connecteurs tels que ceux décrits ci-avant, il devient alors impossible, faute de place de brancher ces derniers ou de les brancher sans déconnecter les systèmes électroniques à tester.

Un autre inconvénient à utiliser de tels boîtiers connecteurs est relatif à la difficulté d'obtenir un blindage efficace, l'amélioration du blindage imposant encore une augmentation du volume.

La présente invention a pour but de remédier efficacement aux divers inconvénients précités tout en proposant un dispositif d'une grande simplicité de mise en oeuvre, d'un coût réduit et qui offre de très bonnes performances.

Pour cela le dispositif connecteur adaptateur de terminaison du genre mentionné dans le préambule est remarquable en ce que le moyen de support et de liaison est un circuit imprimé souple, la liaison entre le connecteur du premier genre et le circuit imprimé souple étant obtenue au moyen de connexions autodénudantes à fente portées par ledit connecteur qui viennent perforer, lorsqu'il existe, l'isolant du circuit imprimé souple et enserrer dans les fentes les extrémités conductrices du circuit imprimé souple spécialement adaptées à cet effet.

Ainsi l'idée de l'invention consiste à utiliser un circuit imprimé souple qui de par sa flexibilité permet d'utiliser pleinement et de la manière la plus simple le volume intérieur du boîtier connecteur tout en supportant efficacement des éléments même volumineux. La mise en oeuvre de cette idée conduit ainsi à un gain de place très significatif. En outre, associées au circuit imprimé souple, les connexions autodénudantes autorisent à une utilisation simple et performante, et le risque de décollement du circuit est évité puisque aucune soudure n'est nécessaire. Enfin un blindage efficace peut être obtenu sans difficulté ni accroissement de volume du fait de l'utilisation d'un circuit imprimé souple compte tenu d'une part de ses propriétés intrinsèques et d'autre part que des plans ou lignes de masse peuvent être facilement intégrés dans l'épaisseur de l'isolant lors de la réalisation dudit circuit imprimé.

Suivant une caractéristique essentielle du dispositif selon l'invention les extrémités conductrices du circuit imprimé souple sont remarquables en ce qu'elles ne sont pas recouvertes d'isolant et ont une largeur prédéterminée, fonction de la largeur des fentes des connexions autodénudantes, la largeur des extrémités conductrices étant légèrement supérieure à la largeur des fentes de manière à assurer une connexion forcée. De cette manière chaque connexion autodénudante vient perforer, lorsqu'il existe, l'isolant situé de part et d'autre de chaque extrémité conductrice alors que celle-ci est enserrée, écrouie et vient épouser parfaitement la forme de la fente.

Bien entendu lorsque les extrémités conductrices débouchent libres de tout support et qu'il n'existe donc pas d'isolant de part et d'autre de chacune d'entre elles, chaque connexion autodénudante vient directement, sans perforation, enserrer, écrouir une extrémité conductrice de sorte qu'elle épouse la forme de la fente. Le principal intérêt à utiliser un circuit imprimé souple dont les extrémités conductrices débouchent libres de tout support réside en une plus grande facilité d'adaptation du circuit imprimé souple à tout connecteur, la flexibilité de l'extrémité conductrice étant dans ce cas encore améliorée.

De manière caractéristique également les extrémités du circuit imprimé souple sont remarquables en ce qu'elles sont d'une épaisseur au moins deux fois supérieure à l'épaisseur des autres parties conductrices du circuit imprimé souple. Ainsi les extrémités conductrices qui sont spécialement adaptées pour coopérer avec les connexions autodénudantes sont enserrées sur une hauteur plus importante ce qui permet de réaliser des contacts de grande qualité.

En outre, selon une caractéristique additionnelle au moins deux des extrémités conductrices adjacentes ou non peuvent être reliées entre elles au moyen d'une liaison par encre conductrice et trous métallisés, l'encre conductrice étant alors disposée dans l'épaisseur de l'isolant transversalement aux lignes conductrices alors que la liaison entre lignes conductrices et encre conductrice est sélectivement obtenue au moyen de trous métallisés. Ceci permet de réaliser aisément une liaison entre lignes et également d'améliorer encore le blindage lorsqu'une pluralité de lignes de masse sont reliées entre elles en un point commun juste en amont des extrémités conductrices.

Selon l'invention le circuit imprimé souple peut également former une boucle dont les deux extrémités sont reliées au connecteur. Ceci permet d'insérer les éléments d'adaptation et/ou de simulation à l'intérieur de la boucle, ce qui peut avoir pour effet également d'améliorer le blindage tout en garantissant un gain de place important et une grande facilité d'insertion dans le boîtier.

Pour encore améliorer la flexibilité et la facilité d'insertion dans le boîtier, le circuit imprimé souple peut être, lorsqu'il a la forme d'une boucle,pourvu de part et d'autre de sa partie médiane de deux découpes transversales portées par le même axe, chaque découpe s'étendant sur environ un tiers de la largeur du circuit imprimé souple et se terminant à l'intérieur du circuit par un évidement circulaire de manière à éviter la propagation des découpes transversales.

Afin de recevoir les éléments d'adaptation et/ou de simulation, le circuit imprimé souple est pourvu d'emplacements conducteurs non recouverts d'isolant lesdits éléments pouvant alors être aisément fixer au moyen de brasures.

Enfin, suivant une dernière caractéristique du dispositif selon l'invention les extrémités conductrices et les emplacements conducteurs non recouverts d'isolant du circuit imprimé souple peuvent être protégés lors de la fabrication par un composé antioxydant, par exemple un alliage de plomb et d'étain déposé par étamage.

La description suivante en regard des dessins annexés, le tout donné à titre d'exemple, fera bien comprendre comment l'invention peut être réalisée.

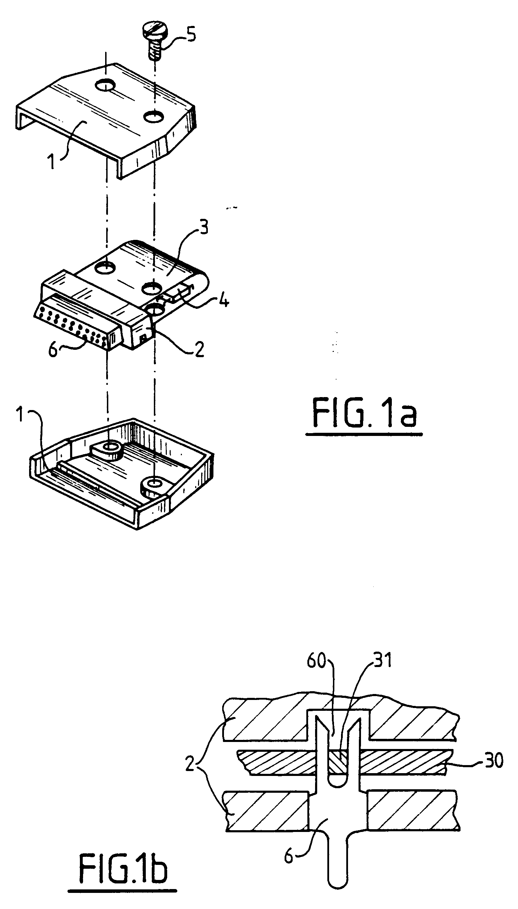

La figure la représente un exemple de dispositif connecteur adaptateur de terminaison selon l'invention et la figure 1b un détail relatif à la liaison entre un circuit imprimé souple et une connexion autodénudante.

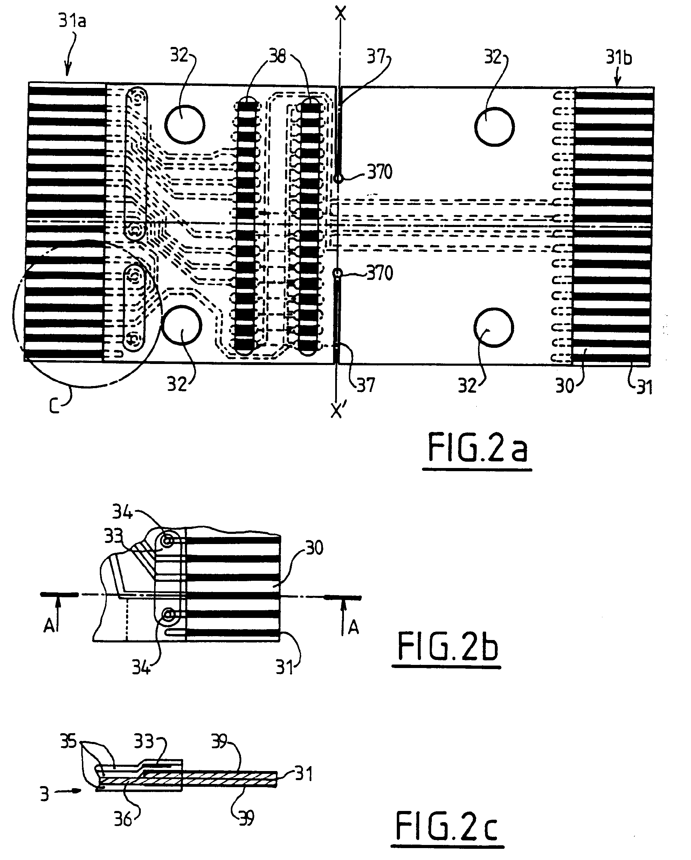

La figure 2a propose un exemple de réalisation du circuit imprimé souple alors que les figures 2b et 2c montrent des détails de réalisation d'une partie repérée de la figure 2a.

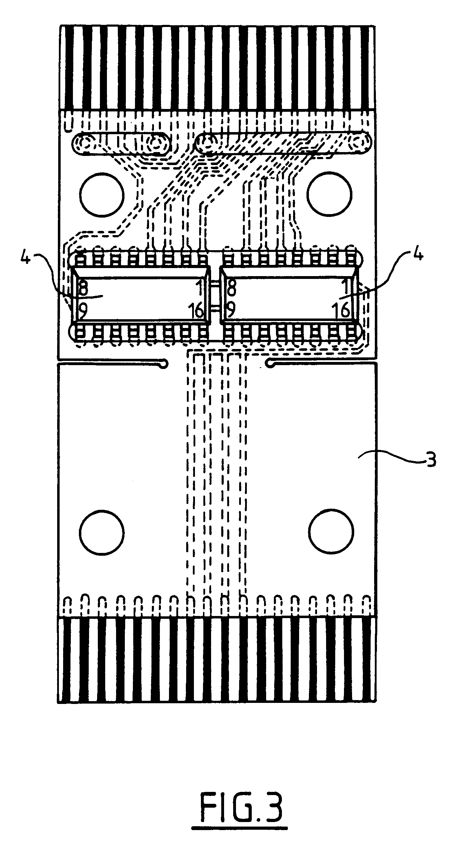

La figure 3 présente une réalisation du circuit imprimé souple muni d'éléments d'adaptation et/ou de simulation. Sur la figure 1a est proposé un exemple de réalisation non limitatif de dispositif connecteur adaptateur de terminaison pour lequel est utilisée et mise en oeuvre l'idée de l'invention. Le dispositif comprend un boîtier de connecteur 1 composé d'une partie supérieure et d'une partie inférieure et qui peut être tout boîtier du commerce, ce qui, puisqu'aucune adaptation ni aucun usinage n'est nécessaire, présente également un avantage. Logé dans le boîtier un connecteur 2 d'un premier genre (par exemple femelle) destiné à être connecté à l'extrémité d'une ligne d'un système électronique à un connecteur (non représenté) d'un second genre (par exemple mâle si le connecteur du premier genre est de type femelle), sur lequel transitent des signaux, pour adapter ladite ligne et/ou simuler la connexion de la ligne à un dispositif extérieur. Egalement logé dans le boîtier et relié au connecteur 2 se trouve enfin le moyen de support et de liaison 3 d'éléments d'adaptation et/ou de simulation 4. La partie supérieure et la partie inférieure du boîtier 1 sont réunies par l'intermédiaire d'un moyen de fixation 5 (vis, boulon, clip, etc..)

Conformément à l'idée de l'invention le moyen de support et de liaison 3 est un circuit imprimé souple dont la liaison avec le connecteur 2 est obtenue au moyen de connexions autodénudantes 6 à fente portées par le connecteur 2 (par exemple des connexions autodénudantes fabriquées par la société 3M). Comme le montre la figure 1b, une connexion autodénudante 6 vient perforer l'isolant 30 (qui existe dans cet exemple d'application) du circuit imprimé souple 3 et enserrer dans la fente 60 en forme de U l'extrémité conductrice 31 du circuit imprimé souple 3, extrémité 31 qui est spécialement adaptée à cet effet.

Pour cela les extrémités conductrices 31 du circuit imprimé souple 3 ne sont pas recouvertes d'isolant et ont une largeur prédéterminée, fonction de la largeur des fentes des connexions autodénudantes 6 et donc du choix desdites connexions.

Ainsi la largeur des extrémités conductrices doit être légèrement supérieure à la largeur des fentes en U de manière à assurer une connexion forcée lorsque la connexion vient enserrer dans sa fente l'extrémité conductrice ce qui, par conséquent, garantit un contact de bonne qualité.

Sur la figure 2a est représenté un exemple de réalisation d'un circuit imprimé souple dont l'isolant peut être constitué de Kapton (marque déposée par E.I. Du Pont de Nemours and Compagny), d'Upilex (marque déposée par Ube Industries, Inc) ou de tout autre matériau de caractéristiques similaires.

De manière connue le circuit imprimé souple est constitué de liaisons ou pistes en cuivre d'une épaisseur d'environ 100 µm recouvertes sur leurs deux faces d'une ou plusieurs couches d'isolant. Lesdites pistes en cuivre permettent de relier les éléments d'adaptation et/ou de simulation (voir figure 3) aux extrémités conductrices 31.

Sur le dessin sont représentées 36 extrémités conductrices 31a et 31b, 18 (31a) d'un côté du circuit 3 et 18 (31b) de son autre côté. Un tel circuit sera donc associé à un connecteur à 36 contacts sur 2 rangées et donc à 36 connexions autodénudantes. Pour le cas où les moyens de fixation 5 des deux parties du boîtier connecteur 1 (figure 1a) sont des vis ou des boulons, quatre trous 32 sont réalisés dans le circuit imprimé souple 3 pour permettre le passage de ces moyens de fixation.

Afin d'autoriser à une meilleure appréhension de la structure du circuit imprimé souple 3, sont proposés sur la figure 2b un agrandissement dudit circuit dans la zone entourée par le cercle C (figure 2a) et sur la figure 2c, une coupe suivant AA de la partie représentée à la figure 2b.

Ainsi selon une des caractéristiques du dispositif selon l'invention chaque extrémité conductrice du circuit imprimé souple 3 est d'une épaisseur au moins deux fois supérieure, par exemple de l'ordre de 250 µm, à l'épaisseur des autres parties conductrices (épaisses d'environ 100 µm) du circuit 3. En outre, on peut voir que, comme cela a été dit précédemment, les extrémités conductrices 31 ne sont pas recouvertes d'isolant.

De même les figures 2b et 2c permettent de voir comment deux extrémités conductrices 31, adjacentes ou non (sur la figure 2b elles ne sont pas adjacentes), peuvent être reliées entre elles au moyen d'une liaison par encre conductrice 33 et trous métallisés 34. L'encre conductrice est disposée dans l'épaisseur de l'isolant (sur la figure 2c elle est disposée entre deux couches d'isolant 35) transversalement aux lignes conductrices 36 alors que la liaison entre lignes conductrices 36 et encre conductrice 33 est sélectivement obtenue au moyen de trous métallisés 34. Une couche d'encre conductrice peut être réalisée par exemple par sérigraphie au moyen d'une encre contenant de l'argent.

Dans un mode de réalisation préféré du dispositif selon l'invention, le circuit imprimé souple 3 forme une boucle, représentée à la figure 1a, dont les deux extrémités, constituées par les extrémités conductrices 31a et 31b sont reliées au connecteur 2 (figure 1a).

Dans ce mode de réalisation préféré, afin d'améliorer encore la flexibilité et de faciliter l'insertion et la mise en forme du circuit imprimé souple dans le boîtier 1 (figure 1a), ledit circuit 3 est pourvu de part et d'autre de sa partie médiane de deux découpes transversales 37 portées par le même axe XX′, chaque découpe s'étendant sur environ un tiers de la largeur du circuit imprimé souple 3 et se terminant à l'intérieur du circuit par une évidement circulaire 370.

Enfin, le circuit imprimé souple 3 est pourvu d'emplacements conducteurs 38 non recouverts d'isolant qui sont prévus pour recevoir les éléments d'adaptation et/ou de simulation tels que ceux décrits en relation avec la figure 3. en outre, les emplacements conducteurs 38 ainsi que les extrémités conductrices 31a et 31b peuvent être protégés par un composé antioxydant 39, par exemple un alliage de plomb et d'étain qui serait déposé par étamage lors de la fabrication du circuit 3 et qui pourrait avoir pour épaisseur environ une dizaine de microns.

Sur la figure 3, le circuit imprimé souple 3 , tel que décrit en regard des figures 2a, 2b, 2c, est représenté pourvu d'éléments d'adaptation et de simulation 4 qui peuvent être dans cet exemple de réalisation deux circuits intégrés du type ULN 2003D de chez Texas, MC 1413 D de chez Motorola ou de tout équivalent, comportant chacun une pluralité de transistors de type NPN équipé chacun d'une résistance de base et organisés de manière à fournir des montages de type Darlington. Un tel dispositif connecteur adaptateur de terminaison permet d'adapter et de simuler à la sortie d'un ordinateur par exemple une imprimante.

En conclusion, en raison du gain de place entraîné par le dispositif selon l'invention celui-ci peut être avantageusement utilisé lorsque les éléments d'adaptation et/ou de simulation à y insérer sont volumineux, par exemple tels que des circuits intégrés, et lorsque la place pour le recevoir est limitée. Il est d'un coût réduit, un boîtier du commerce pouvant être utilisé sans nécessité d'adaptation, et ne demande pas la mise en oeuvre de techniques complexes, il est au contraire d'une utilisation aisée. Il permet en outre d'améliorer le blindage de manière simple sans pour autant engendrer un accroissement de volume.

## Revendications

1. Dispositif connecteur adaptateur de terminaison comprenant, entre autres, un boîtier (1), logé dans le boîtier un connecteur (2) d'un premier genre destiné à être connecté à l'extrémité d'une ligne d'un système électronique à un connecteur d'un second genre, sur lequel transitent des signaux, pour adapter ladite ligne et/ou simuler la connexion de la ligne à un dispositif extérieur, également logé dans le boîtier (1) et relié au connecteur (2) du premier genre un moyen (3) de support et de liaison d'éléments (4) d'adaptation et/ou de simulation, caractérisé en ce que le moyen (3) de support et de liaison est un circuit (3) imprimé souple, la liaison entre le connecteur (2) du premier genre et le circuit (3) imprimé souple étant obtenue au moyen de connexions autodénudantes (6) à fente portées par ledit connecteur (2) qui viennent perforer, lorsqu'il existe, l'isolant (30) du circuit (3) imprimé souple et enserrer dans les fentes (60) les extrémités (31) conductrices du circuit (3) imprimé souple spécialement adaptées à cet effet.

2. Dispositif connecteur adaptateur de terminaison selon la revendication 1 caractérisé en ce que les extrémités (31) conductrices du circuit imprimé souple ne sont pas recouvertes d'isolant et ont une largeur prédéterminée, fonction de la largeur des fentes (60) des connexions autodénudantes, la largeur des extrémités conductrices étant légèrement supérieure à la largeur des fentes de manière à assurer une connexion forcée.

3. Dispositif connecteur adaptateur de terminaison selon la revendication 1 ou 2 caractérisé en ce que les extrémités (31) conductrices du circuit (3) imprimé souple sont d'une épaisseur au moins deux fois supérieure à l'épaisseur des autres parties conductrices du circuit (3) imprimé souple.

4. Dispositif connecteur adaptateur de terminaison selon l'une des revendication 1 à 3 caractérisé en ce que au moins deux extrémités (31) conductrices, adjacentes ou non, peuvent être reliés entre elles au moyen d'une liaison par encre conductrice et trous métallisés, l'encre (33) conductrice étant alors disposée dans l'épaisseur de l'isolant (35) transversalement aux lignes conductrices (36) alors que la liaison entre lignes conductrices et encre conductrice est sélectivement obtenue au moyen de trous (34) métallisés.

5. Dispositif connecteur adaptateur de terminaison selon l'une des revendications 1 à 4 caractérisé en ce que le circuit (3) imprimé souple forme une boucle dont les deux extrémités (31a,31b) sont reliées au connecteur (2).

6. Dispositif connecteur adaptateur de terminaison selon la revendication 5 caractérisé en ce que le circuit (3) imprimé souple est pourvu de part et d'autre de sa partie médiane de deux découpes (37) transversales portées par le même axe (X,X′), chaque découpe s'étendant sur environ un tiers de la largeur du circuit (3) imprimé souple et se terminant à l'intérieur du circuit par un évidement circulaire (370).

7. Dispositif connecteur adaptateur de terminaison selon l'une des revendications précédentes caractérisé en ce que le circuit (3) imprimé souple est pourvu d'emplacements (38) conducteurs non recouverts d'isolant prévus pour recevoir les éléments (4) d'adaptation et/ou de simulation.

8. Dispositif connecteur adaptateur de terminaison selon l'une des revendications précédentes caractérisé en ce que les extrémités (31) conductrices et les emplacements (38) conducteurs non recouverts d'isolant du circuit imprimé souple sont protégés par une composé (39) antioxydant.

## Patentansprüche

1. Abschlußadapter-Verbindungsvorrichtung, die unter anderem ein Gehäuse (1) enthält sowie in dem Gehäuse aufgenommen einen Verbinder (2) einer ersten Art, der dazu vorgesehen ist, am Ende einer Leitung eines elektronischen Systems mit einem Verbinder einer zweiten Art, über den Signale übertragen werden, verbunden zu werden, um die Leitung anzupassen und/oder die Verbindung der Leitung mit einer externen Vorrichtung zu simulieren, die ebenfalls in dem Gehäuse (1) aufgenommen und mit dem Verbinder (2) der ersten Art über ein Halte- und Verbindungsmittel (3) für Adapter- und Simulationselemente (4) verbunden ist, dadurch gekennzeichnet, daß das Halte- und Verbindungsmittel (3) eine nachgiebige gedruckte Schaltung (3) ist, wobei die Verbindung zwischen dem Verbinder (2) der ersten Art und der nachgiebigen gedruckten Schaltung (3) mittels einen Schlitz aufweisender, selbstabisolierender Anschlußstifte (6) erhalten wird, die vom Verbinder (2) getragen sind und die, so sie vorhanden ist, die Isolierung (30) der nachgiebigen gedruckten Schaltung (3) durchdringen und in den Schlitzen (60) die zu diesem Zweck speziell ausgeführten Leiterenden (31) der nachgiebigen gedruckten Schaltung (3) festklemmen.

2. Abschlußadapter-Verbindungsvorrichtung nach Anspruch 1, dadurch gekennzeichnet, daß die Leiterenden (31) der nachgiebigen gedruckten Schaltung nicht mit einer Isolierung bedeckt sind und eine vorbestimmte Breite aufweisen, die von der Breite der Schlitze (60) der selbstabisolierenden Anschlußstifte abhängt, wobei die Breite der Leiterenden geringfügig größer als die Breite der Schlitze ist, um eine kraftschlüssige Verbindung zu gewährleisten.

3. Abschlußadapter-Verbindungsvorrichtung nach Anspruch 1 oder 2, dadurch gekennzeichnet, daß die Leiterenden (31) der nachgiebigen gedruckten Schaltung (3) eine Dicke aufweisen, die wenigstens zweimal größer als die Dicke der anderen Leiterabschnitte der nachgiebigen gedruckten Schaltung (3) ist.

4. Abschlußadapter-Verbindungsvorrichtung nach einem der Ansprüche 1 bis 3, dadurch gekennzeichnet, daß wenigstens zwei benachbarte oder nicht benachbarte Leiterenden (31) miteinander über eine aus leitfähiger Farbe und metallisierten Löchern gebildete Verbindung verbunden werden können, wobei die leitfähige Farbe (33) dann in der Dicke der Isolierung (35) quer zu den Leiterbahnen (36) angeordnet ist und die Verbindung zwischen den Leiterbahnen und der leitfähigen Farbe selektiv mittels metallisierter Löcher (34) erhalten wird.

5. Abschlußadapter-Verbindungsvorrichtung nach einem der Ansprüche 1 bis 4, dadurch gekennzeichnet, daß die nachgiebige gedruckte Schaltung (3) eine Schleife bildet, deren beide Enden (31a, 31b) mit dem Verbinder (2) verbunden sind.

6. Abschlußadapter-Verbindungsvorrichtung nach Anspruch 5, dadurch gekennzeichnet, daß die nachgiebige gedruckte Schaltung (3) beiderseits ihres mittleren Abschnittes mit zwei auf der gleichen Achse (X-X′) liegenden Quereinschnitten (37) versehen ist, wobei sich jeder Einschnitt über ungefähr ein Drittel der Breite der nachgiebigen gedruckten Schaltung (3) erstreckt und im Inneren der Schaltung in einer kreisförmigen Aussparung (370) endet.

7. Abschlußadapter-Verbindungsvorrichtung nach einem der vorangehenden Ansprüche, dadurch gekennzeichnet, daß die nachgiebige gedruckte Schaltung (3) mit nicht von der Isolierung bedeckten Leiterstellen (38) versehen ist, die dafür vorgesehen sind, die Adapter- und Simulationselemente (4) aufzunehmen.

8. Abschlußadapter-Verbindungsvorrichtung nach einem der vorangehenden Ansprüche, dadurch gekennzeichnet, daß die Leiterenden (31) und die nicht von der Isolierung bedeckten Leiterstellen (38) der nachgiebigen gedruckten Schaltung durch eine Antioxidationsverbindung (39) geschützt sind.

## Claims

1. A termination adaptor connector device, comprising amongst other things a housing (1) and, accommodated within the housing, a first type of connector (2) intended to be connected to the end of a line of an electronic system having a second type of connector, over which signals are routed, in order to adapt said line and/or simulate the connection of the line to an external device and, also accommodated in the housing (1) and connected to the first type of connector (2), a support and linking means (3) for adaptation and/or simulation elements (4), characterised in that the support and linking means (3) is a flexible printed circuit (3), the link between the first type of connector (2) and the flexible printed circuit (3) being obtained by means of slotted self-stripping connections (6) carried by said connector (2) which perforate the insulation (30), if any, of the flexible printed circuit (3) and enclose within the slots (60) the conducting ends (31) of the flexible printed circuit (3) specially suited to this purpose.

2. A termination adaptor connector device according to Claim 1, characterised in that the conducting ends (31) of the flexible printed circuit are not covered with insulation and have a predetermined width, which is a function of the width of the slots (60) of the self-stripping connections, the width of the conducting ends being slightly greater than the width of the slots so as to make a forced connection.

3. A termination adaptor connector device according to Claim 1 or 2, characterised in that the conducting ends (31) of the flexible printed circuit (3) are at least twice as thick as the thickness of the other conducting parts of the flexible printed circuit (3).

4. A termination adaptor connector device according to one of Claims 1 to 3, characterised in that at least two conducting ends (31), adjacent or otherwise, can be connected together by means of a link made by conducting ink and metallised holes, the conducting ink (33) then being disposed inside the thickness of the insulation (35) transverse to the conducting lines (36) while the link between conducting lines and conducting ink is selectively obtained by means of metallised holes (34).

5. A termination adaptor connector device according to one of Claims 1 or 4, characterised in that the flexible printed circuit (3) forms a loop, both ends (31a, 31b) of which are connected to the connector (2).

6. A termination adaptor connector device according to Claim 5, characterised in that the flexible printed circuit (3) is provided on either side of its median part with two transverse cut-outs (37) carried on the same axis (X-X), each cut-out extending over about one third of the width of the flexible printed circuit (3) and ending inside the circuit in a circular recess (370).

7. A termination adaptor connector device according to one of the preceding claims, characterised in that the flexible printed circuit (3) is provided with conducting locations (38) not covered with insulation provided in order to receive the adaptation and/or simulation elements (4).

8. A termination adaptor connector device according to one of the preceding claims, characterised in that the conducting ends (31) and the conducting locations (38), not covered with insulation, of the flexible printed circuit are protected with an antioxidant compound (39).
